# EUROPEAN PATENT APPLICATION

(11) **EP 2 860 761 A1**
(43) Date of publication of application: **15.04.2015**
(21) Application number: 13797744.3
(22) Date of filing: 23.04.2013
(51) Int. Cl.: H01L 29/78, H01L 29/12

(54) **SEMICONDUCTOR DEVICE**

(30) Priority: 31.05.2012 JP 2012125173
(71) Applicant: National Institute Of Advanced Industrial Science, Tokyo 100-8921 (JP)
(72) Inventor: HARADA Shinsuke, Tsukuba-shi Ibaraki 305-8568 (JP)
(74) Representative: Williams, Michael Ian
(86) International application number: PCT/JP2013/061898
(87) International publication number: WO 2013/179820

(57) **Abstract**

In a super junction structure of a trench gate type MOSFET that contains silicon carbide as a substrate material, the dielectric breakdown electric field of silicon carbide is higher by approximately an order of magnitude than that of silicon. Although silicon carbide can maintain a high electric field, the high electric field is also applied to a peripheral insulating oxide film. In a conventional structure, there is a problem that the high electric field is applied to a gate oxide film on a bottom of a trench, and the device is broken as a result of dielectric breakdown of the insulating oxide film at a low voltage before dielectric breakdown of silicon carbide. In the present invention, a p-type pillar layer constituting a super junction is formed separately into an upper layer in contact with a base layer and an underlying lower layer. The upper layer has a higher impurity concentration than the lower layer. An interface between the upper layer and the lower layer of the pillar layer and a contact point between the interface and a drift layer are located below the bottom of a trench groove. This allows depletion in an upper portion of an n-type pillar to occur at a lower voltage than in a lower portion thereof in the blocking state. Thus, the application of an electric field to an oxide film can be suppressed without sacrificing the other characteristics, and the device is successfully prevented from being broken.

## Description

### Technical Field

The present invention relates to a silicon carbide semiconductor device in which low on-resistance and high voltage resistance of a semiconductor switching device for power conversion are achieved by using a silicon carbide substrate.

### Background Art

As a semiconductor switching device for power conversion that uses a silicon carbide substrate, a trench gate type MOSFET has a small unit cell structure and a high current density and is therefore effective in reducing on-resistance.

In a high-voltage device in which the resistance of a drift layer is predominant, a super junction structure, which forms a repetition of p-type and n-type pillars in the drift layer, is effective in reducing drift layer resistance. These structures can be combined to realize a low-resistance and high-voltage switching device.

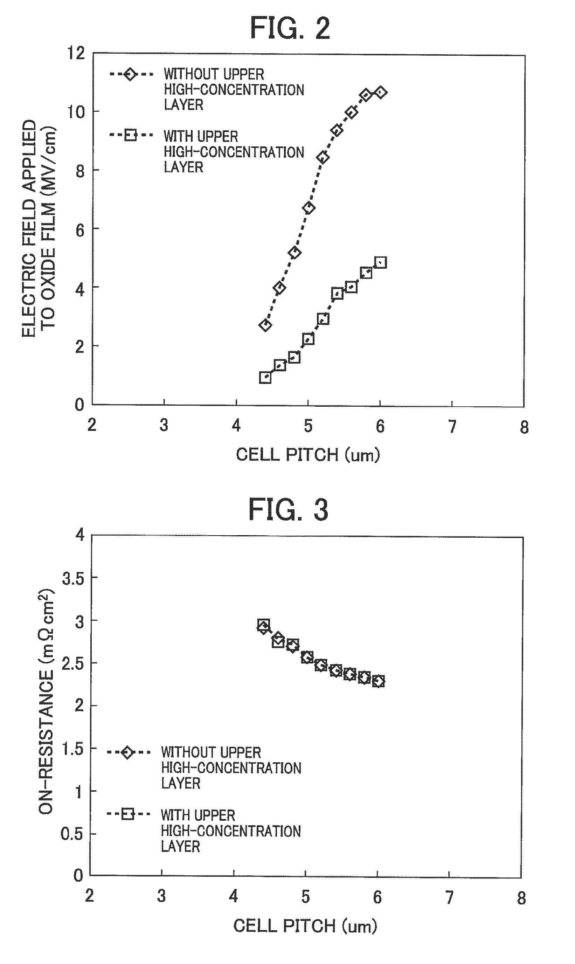

This technique is used in a semiconductor device that includes a substrate formed of a conventional power semiconductor material silicon. For example, Fig. 2 of Patent Reference 1 discloses a structure that is provided with a p-type pillar layer between trench gates.

In this structure, an electric field exists not only in the vertical direction from a p-base to a drain but also in the transverse direction from a pillar, and the electric field is not concentrated in a particular portion.

Thus, high blocking voltage can be maintained even when the concentration of n-type impurity in the n-type pillar layer, which is an electric current path in the on state, is increased.

However, the dielectric breakdown electric field of silicon carbide is higher by approximately an order of magnitude than that of silicon. Although silicon carbide can maintain a high electric field, the high electric field is also applied to a peripheral insulating oxide film. In a conventional structure, the high electric field is applied to a gate oxide film on the bottom of a trench, and the device may be broken as a result of dielectric breakdown of the insulating oxide film at a low voltage before dielectric breakdown of silicon carbide.

As a conventional structure for protecting a gate oxide film on the bottom of a trench, Patent Reference 2 discloses a structure in which a p-base is deepened at a portion apart from the trench.

This allows a depletion layer to be extended from the p-base and a trench gate oxide film to be protected from a high electric field in the blocking state, thereby preventing breakdown of the device due to dielectric breakdown of the oxide film and achieving high voltage resistance.

In contrast, a super junction structure, which has a p-type pillar in a drift layer, has the same effect in a sense that the depletion layer is expanded in the transverse direction. However, because the depletion layer is expanded on both sides of n-type and p-type pillars, the expansion on the n-type side is insufficient to protect a trench gate oxide film.

Thus, there is a need for a structure for protecting an oxide film suitable for a super junction structure of a trench gate.

Patent Reference 3 discloses a structure that includes a high-concentration p-type region in a junction at a portion connecting a super junction structure and a p-base. This allows a breakdown to occur on the bottom of the high-concentration p-type region, facilitates the flow of an avalanche electric current to a p+ contact, and can improve avalanche capability.

However, the effect of protecting a trench gate oxide film is not clear.

### Prior Art List

### Patent References

Patent Reference 1: Japanese Unexamined Patent Application Publication No. 2009-43966
Patent Reference 2: Japanese Unexamined Patent Application Publication No. 2009-260253
Patent Reference 3: Japanese Unexamined Patent Application Publication No. 2012-39082

### Summary of the Invention

### Problem to be solved by the Inveniton

The present invention provides a structure for protecting a gate oxide film from a high electric field in a super junction structure of a trench gate type MOSFET that contains silicon carbide as a substrate material. Measn for solving the Problem

The present invention provides a semiconductor device that includes a first conductive type drift layer on a silicon carbide substrate, a second conductive type base layer stacked on the first conductive type drift layer, a first conductive type source region formed in a predetermined region on a surface of the base layer, a trench groove that passes through the source region and a base region, a gate electrode formed in at least part of the trench groove with a gate-insulating film interposed therebetween, and a super junction layer that is composed of a second conductive type pillar layer formed in contact with the base layer in the drift layer, wherein the second conductive type pillar layer includes an upper layer and an underlying lower layer, the upper layer being in contact with the base layer, the upper layer has a higher impurity concentration than the lower layer, and an interface between the upper layer and the lower layer of the second conductive type pillar layer and a contact point between the interface and the first conductive type pillar layer are located below the bottom of the trench groove.

Thus, a contact point between an upper layer of a p-type pillar layer and an n-type pillar has a high concentration. This allows depletion in an n-type pillar layer adjacent to a p-type pillar upper layer portion to occur at a lower voltage than in a lower portion of the p-type pillar layer in the blocking state. Furthermore, because the contact point between the upper layer of the p-type pillar layer and the n-type pillar extends below a trench gate oxide film, the gate oxide film can be surrounded by a depletion layer and can be shielded from a high electric field. This can prevent breakdown of the device resulting from dielectric breakdown of the oxide film, thereby achieving high blocking voltage.

The present invention also provides the semiconductor device in which the width of an upper layer of the second conductive type pillar is equal to or greater than the width of a lower layer of the second conductive type pillar.

This allows depletion in the n-type pillar layer adjacent to the p-type pillar upper layer portion to occur at a lower voltage in the blocking state, thereby preventing breakdown of the device due to dielectric breakdown of the oxide film and achieving high blocking voltage.

There is also provided the semiconductor device in which the second conductive type pillar layer has a stripe shape parallel to the trench groove when viewed from above.

There is also provided the semiconductor device in which the second conductive type pillar layer has a stripe shape perpendicular to the trench groove when viewed from above.

Finally, there is provided the semiconductor device in which the second conductive type pillar layer is interspersed as islands when viewed from above, and the trench groove is hexagonal around the pillar layer that serves as the center of the hexagonal when viewed from above.

### Effect of the Invention

In accordance with the present invention, a contact point between an upper layer of a p-type pillar layer and an n-type pillar in a super junction has a high concentration. This allows depletion in an n-type pillar layer adjacent to
a p-type pillar upper layer portion to occur at a lower voltage than in a lower portion of the p-type pillar layer in the blocking state. Because the contact point between the upper layer of the p-type pillar layer and the n-type pillar extends below a trench gate oxide film, the gate oxide film can be surrounded by a depletion layer and can be shielded from a high electric field. This can prevent breakdown of the device resulting from dielectric breakdown of the oxide film, thereby achieving high blocking voltage.

### Brief Description of the Drawings

[Fig. 1] Fig. 1 is a cross-sectional view of a striped or island-shaped unit structure (unit cell) of a semiconductor device according to the present invention.
[Fig. 2] Fig. 2 is a view showing the cell pitch dependency of the electric field characteristics of an oxide film in which the concentration of impurity in a p-type pillar is uniform or is increased in an upper layer.
[Fig. 3] Fig. 3 is a view showing the cell pitch dependency of the on-resistance characteristics in which the concentration of impurity in a p-type pillar is uniform or is increased in an upper layer.
[Fig. 4] Fig. 4(a) is a schematic plan view of a striped semiconductor device according to the present invention in which p-type pillars and gate trenches are disposed parallel to each other. Fig. 4(b) is a schematic plan view of a striped semiconductor device according to the present invention in which p-type pillars and gate trenches are disposed perpendicular to each other.
[Fig. 5] Fig. 5 is a schematic plan view of a semiconductor device according to the present invention in which an island-shaped p-type pillar is surrounded by an n-type pillar.

### Modes for carrying out the Invention

### EMBODIMENT 1

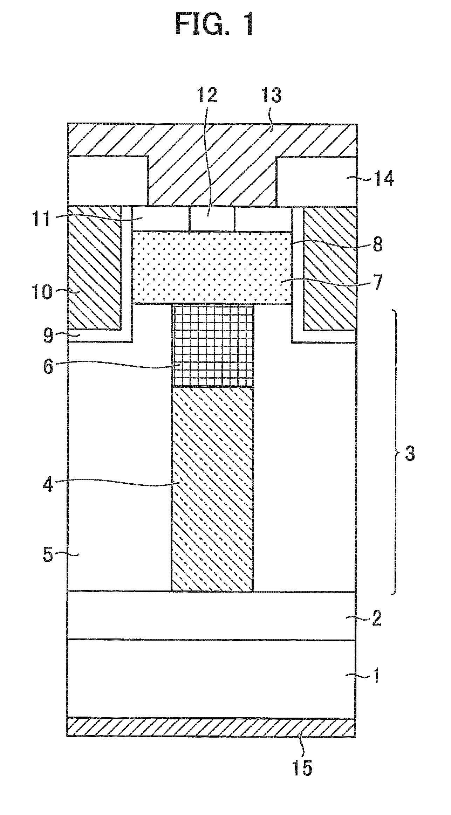

Fig. 1 is a cross-sectional view of a striped or island-shaped unit structure (unit cell) of a semiconductor device according to a first embodiment of the present invention.

A drift layer 2 is disposed on a low-resistance n+ type 4H-SiC substrate 1.

P-type pillars 4 and n-type pillars 5 are disposed on the drift layer 2 at regular intervals, thereby constituting a super junction region 3.

The shape when viewed from above may be a striped shape or a structure in which an island-shaped p-type pillar is surrounded by an n-type pillar, for example, a hexagonal shape.

An upper portion of the p-type pillar layer is a high-concentration p-type layer 6 and has a high concentration ratio relative to the n-type pillar. Thus, in the blocking state, depletion in an upper portion of the n-type pillar occurs at a lower voltage than in a lower portion thereof.

A p-type base layer 7 is stacked on the super junction region 3. A gate trench 8 extends from a surface of the p-type base layer 7 to the super junction region 3.

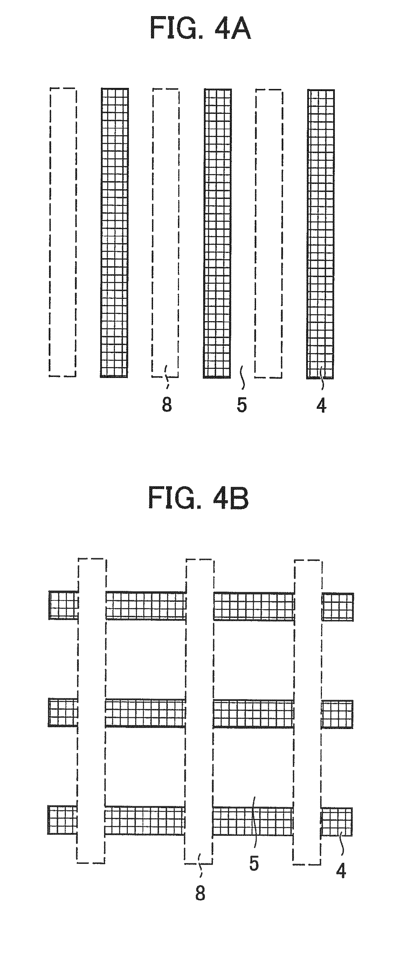

In the case of striped pillars as illustrated in Fig. 4, the direction of the gate trench 8 when viewed from above may be optional, for example, parallel (Fig. 4(a)) or perpendicular (Fig. 4(b)) to the pillars.

In the case where the p-type pillars are parallel to the gate trenches, the gate trenches are arranged inside the n-type pillar layers such that the gate trenches pass through the n-type pillar layers.

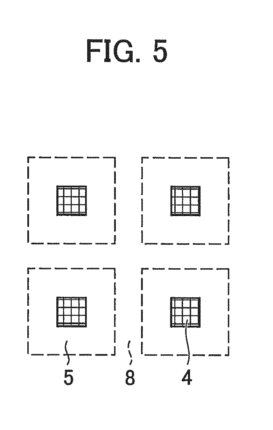

As illustrated in Fig. 5, also in the case of island-shaped p-type pillars, the shape of the gate trenches is formed inside the n-type pillars along the shape of the n-type pillars that surround the p-type pillars such that the gate trenches pass through the n-type pillars.

A gate-insulating film 9 and a gate electrode 10 are formed inside the gate trench 8. High-concentration n+ source regions 11 are selectively formed on a surface of the p-type base layer 7 so as to be adjacent to the gate trench 8. A high-concentration p+ base contact region 12 is selectively formed between the source regions 11.

A source electrode 13 is connected to parts of the source regions 11 and the base contact region 12 by low-resistance connection and extends upward through an interlayer insulating film 14.

A drain electrode 15 is connected to the back side of the substrate by low-resistance connection.

Figs. 2 and 3 are comparative results of the cell pitch dependency of the oxide film characteristics and on-resistance characteristics between the case in which the concentration of impurity in a p-type pillar is uniform and the case in which the impurity concentration is increased in an upper layer.

The cell pitch is altered by changing the width of the n-type pillar.

The electric field applied to a gate oxide film in the blocking state in Fig. 2 is greatly reduced by increasing the concentration in an upper portion of the p-type pillar. On the other hand, there is no difference in the on-resistance between the two structures in Fig. 3. This shows that an increase in concentration in the upper portion of the p-type pillar results in suppressed application of an electric field to the oxide film without sacrificing the other characteristics.

### Reference Sign List

- 1: n+ type substrate
- 2: Drift layer
- 3: Super junction region
- 4: p-type pillar
- 5: n-type pillar
- 6: High-concentration p-type layer
- 7: p-type base layer
- 8: Gate trench
- 9: Gate-insulating film (oxide film)
- 10: Gate electrode
- 11: High-concentration n+ source region
- 12: High-concentration p+ base contact region
- 13: Source electrode
- 14: Interlayer insulating film
- 15: Drain electrode

## Claims

1. A semiconductor device, comprising:
a first conductive type drift layer on a silicon carbide substrate;
a second conductive type base layer stacked on the first conductive type drift layer;
a first conductive type source region formed in a predetermined region on a surface of the base layer;
a trench groove that passes through the source region and a base region;
a gate electrode formed in at least part of the trench groove with a gate-insulating film interposed therebetween; and
a super junction layer that is composed of a second conductive type pillar layer formed in contact with the base layer in the drift layer,
wherein the second conductive type pillar layer includes an upper layer and an underlying lower layer, the upper layer being in contact with the base layer,
the upper layer has a higher impurity concentration than the lower layer, and
an interface between the upper layer and the lower layer of the second conductive type pillar layer and a contact point between the interface and the first conductive type pillar layer are disposed below the bottom of the trench groove.

2. The semiconductor device according to Claim 1, wherein a width of an upper layer of the second conductive type pillar layer is equal to or greater than a width of a lower layer of the second conductive type pillar.

3. The semiconductor device according to any one of Claims 1 and 2, wherein the second conductive type pillar layer has a stripe shape parallel to the trench groove when viewed from above.

4. The semiconductor device according to any one of Claims 1 and 2, wherein the second conductive type pillar layer has a stripe shape perpendicular to the trench groove when viewed from above.

5. The semiconductor device according to any one of Claims 1 and 2, wherein the second conductive type pillar layer is interspersed as islands when viewed from above, and the trench groove is hexagonal around the pillar layer that serves as a center of the hexagonal when viewed from above.
